# EUROPEAN PATENT APPLICATION

(11) **EP 2 871 038 A1**
(43) Date of publication of application: **13.05.2015**
(21) Application number: 13191969.8
(22) Date of filing: 07.11.2013
(51) Int. Cl.: B29C 59/14, H05H 1/24, C23C 16/54

(54) **Device for treating a surface**

(71) Applicant: Maan Research & Development B.V., 8102 HR Raalte (NL)
(72) Inventor: Jansen, Andreas Willibrordus Maria, 8131 SZ Wijhe (NL); Snitjer, Johannes Schelto, 8016 DD Zwolle (NL)
(74) Representative: 't Jong, Bastiaan Jacob

(57) **Abstract**

The invention relates to a device for treating a surface by moving the device over the surface in a treatment direction, which device comprises a number of treatment elements arranged in at least one row, wherein the treatment elements within a row are parallel to each other and wherein the longitudinal axis of each treatment element has at least, in use, a directional component parallel to the treatment direction.

## Description

The invention relates to a device for treating a surface by moving the device over the surface in a treatment direction, which device comprises a number of treatment elements arranged in at least one row.

Such a device according to the preamble is shown by WO 02094455. This document discloses a device for plasma treatment of materials under atmospheric pressure. The device is relatively moved over a surface, either by moving the surface or by moving the device.

The device could furthermore be in contact with the surface, or the device could be spaced apart from the surface, such that for example a plasma could be generated between the device and the surface to be treated.

The device according to the prior art has a number of treatment elements arranged in a number of rows. Within each row the treatment elements extend perpendicular to the treatment direction and are arranged overlapping, one behind the other in treatment direction. This overlapping arrangement results in an uneven distribution of the treatment over the width of the row. At the position of the overlap of treatment elements, the surface has a more intense treatment than the other parts, which is undesired.

For treating larger widths it is required that the treatment is homogeneously applied to the surface. With the arrangement according to the prior art, one row applies one treatment to the surface, but at the overlapping parts, the treatment is doubled.

Adjusting the treatment elements within a row, such that there is no overlap, is difficult as the row needs to be completely perpendicular to the treatment direction. It is then also necessary that there is absolutely no space between two elements, seen in treatment direction, as otherwise there will be a reduced treatment at that position. The space mentioned is not related to the physical boundaries of the housing, but to the boundaries of the treatment zone.

Furthermore, there could be a difference in treatment intensity at the ends of an treatment element compared to the remaining length of the element. Having two treatment elements abutting, seen in treatment direction, would result at the abutment zone in that the end effect of the treatment element is doubled. This could again cause an increase or decrease of the surface treatment at the position of the abutment zone.

Also, a treatment could have different results when it is applied once at a high density or twice at half the density, which could occur with the overlapping parts at the device according to the prior art.

When a larger treatment zone is desired, one has to combine a number of rows of overlapping treatment elements as shown in the prior art document WO 02094455. However, due to the overlapping positioning, a bulky arrangement will arise, having considerable gaps in the treatmentzone. Furthermore, the reduced treatment quality at the overlapping and abutment zones will be multiplied by the number of rows used.

It is an object of the invention to reduce or to remove the above mentioned disadvantages.

This object is achieved with a device according to the preamble, which device is **characterized in that** the treatment elements within a row are parallel to each other and wherein the longitudinal axis of each treatment element has at least, in use, a directional component parallel to the treatment direction.

Preferably the treatment elements are arranged in an imbricated way in the direction of the row.

By arranging the treatment elements in an imbricated way in the direction of the row, i.e. like shingles on a roof, a larger treatment area is provided, while having an even treatment along the full treatment area and having a compact design. This treatment area can be as wide as the surface to be treated by arranging sufficienttreatment elements in a row and the length of the treatment area of just one row, can be as long as almost the length of a treatment element.

Due to the more compact design, by providing the elements in imbricated way, the separate treatment of each element, like a plasma cloud or a coating cloud, is combined to a homogeneous treatment zone, which extends over the full treatment area. Thus with the invention it is possible to create a large treatment area composed out of smaller treatment elements.

In an embodiment of the device according to the invention the longitudinal axis of each treatment element is under an angle with the treatment direction and wherein the direction of the longitudinal axis of each treatment element differs from both the treatment direction and the direction of the at least one row.

The treatment elements could be arranged in an imbricated way to ensure even treatment of the full surface. This results in that the longitudinal axis of the treatment elements is under an angle with the treatment direction and the direction of the at least one row. So the longitudinal axis cannot be parallel to the treatment direction and cannot be parallel to the direction of the rows.

If the longitudinal axis of the elements is equal to the treatment direction, the borders of the treatment elements or spacing between the treatment elements could result in an uneven treatment over the length of the row. However, this still could results in a cost effective device which has a large treatment area composed out of smaller treatment elements.

If the longitudinal axis of the elements would be equal to the direction of the row, then the same problems would arise as in the prior art. Therefor, the direction of the longitudinal axis of each treatment element should differ from both the treatment direction and the direction of the at least one row.

Accordingly, it is preferred that the angle between the longitudinal axis of each treatment element and the treatment direction is equal to or larger than 0° and smaller than 90°.

In a very preferred embodiment of the device according to the invention the treatment elements are surface dielectric barrier discharge plasma heads having linear electrodes extending in longitudinal direction of the elements.

Such surface dielectric barrier discharge plasma heads typically have a thin ceramic plate. On each side of the ceramic plate an electrode is arranged and a high frequency voltage is applied to the electrodes. This results in a linear plasma cloud on one side around the electrode of the gas surrounding the electrode. This arrangement makes it possible to bring the generated plasma very close to the surface to be treated.

Large ceramic plates are difficult to handle and accordingly costly to produce. With the invention, it is possible to use small ceramic plates, which are commonly available on the market, for the treatment elements and still provide a large treatment zone with the arrangement according to the invention.

Other principals for generating plasma could also be used in the device according to the invention. For example, a plasma can also be generated at a spot and then be transported by a stream of gas. Such a gas transported plasma could be blown through a linear mouth, which can easily be arranged in the device according to the invention. The linear mouth could be provided by an array of small openings.

Another possibility would be to blow the plasma out of a rotating nozzle and to arrange a number of such nozzles in a row to arrive at an treatment element.

Also these alternative ways of generating an elongate plasma will encounter problems when they are scaled to larger widths of the surface to be treated. These problems include for example heat problems and problems with creating a homogeneous cloud. With the arrangement of the invention, the treatment elements could remain within reasonable dimensions, while still creating a larger treatment zone.

A further preferred embodiment of the device according to the invention further comprises two triangular treatment elements each arranged at an end of the at least one row of treatment elements to obtain a rectangular treatment area.

If the treatment elements are arranged in the imbricated way, the ends of a row will not be as wide as the middle of the row. One could discard these parts of the row by having them extending past the edges of the surface to be treated. However, by arranging separate triangular treatment elements at the ends of the row, a rectangular treatment area is obtained, which could reach up to the edges of the surface and does not need to extend over these edges.

The triangular elements can also be used within a row, to provide treatment zones, which are clearly delimited.

Yet another embodiment of the device according to the invention comprises at least two parallel rows of treatment elements, wherein the longitudinal axes of the elements of adjacent rows are mirrored relative to the direction of the rows.

In this embodiment at least two rows are provided, wherein the elements in the rows are mirrored. This provides for a wider treatment area, such that a surface can be treated at a higher speed or more thorough at the same speed. The mirroring of the treatment elements ensures that any deviations in the treatment efficiency of a row is further reduced.

The treatment elements of adjacent rows could be combined, by providing for example L-shaped treatment elements, which extend over two rows.

In a further preferred embodiment of the device according to the invention adjacent rows are displaced in longitudinal direction of the rows.

Preferably the displacement of adjacent rows equals the pitch between adjacent treatment elements divided by the number of rows.

This displacement of the treatment elements in the direction of the row further reduces any deviations in the treatment quality of a single row.

In still another preferred embodiment of the device according to the invention a gap is provided between adjacent treatment elements for supplying a treatment gas between the treatment elements and the surface to be treated or for discharging a treatment gas therefrom.

In for example a plasma application, the treatment gas is used for generating the plasma. This gas needs to be supplied at the electrodes arranged in a treatment element. One could arrange small holes near electrodes, but as the treatment element is part of a far larger treatment zone, the gas could also be supplied from the sides through the air gaps. This provides for a simpler and cheaper design.

The treatment gas could be discharged at the edges of the treatment zone, or some of the gaps could be used for discharging the used treatment gas.

Yet another embodiment of the device according to the invention comprises control means for separately controlling the power of the treatment elements.

By controlling the treatment elements separately, one can define zones within the treatment area, such that only a part of the surface is treated.

Still another preferred embodiment of the device according to the invention comprises further a housing for accommodating the at least one row of treatment elements, wherein the housing has a gas inlet for providing a treatment gas to the treatment elements and a gas outlet for discharging the treatment gas from the treatment elements.

The housing provides a single treatment head, which can be arranged in a machine for treating for example a web of material, like a web of paper, or a sheet, like a rectangular panel.. The single treatment head could provide a plasma treatment to this web. Such a plasma treatment can be used for cleaning the surface such that a subsequently applied glue layer will be of a higher quality. The plasma can also be used for coating the surface, for activation of the surface, for arranging an ink substance or for making the surface antibacterial.

In a further very preferred embodiment of the device according to the invention the treatment elements are elongate. Elongate treatment can be manufactured cost effective and will provide a considerable width to the treatment zone, when the elements are arranged in imbricated way, or even with the longitudinal axis in the treatment direction.

It could be of advantage in certain applications to apply treatment elements, having a non-elongate shape, such as triangular or square.

These and other features of the invention will be elucidated in conjunction with the accompanying drawings.
Figure 1 shows a perspective view of an embodiment of a device for treating a surface according to the invention.
Figure 2 shows a schematic partial top view of the embodiment of figure 1.
Figure 3 shows a schematic top view of a second embodiment of a device according to the invention.
Figure 4 shows an embodiment of an treatment element for a device according to the invention.
Figure 5 shows a cross sectional view of a third embodiment of a device according to the invention.
Figure 6 shows a fourth embodiment of a device according to the invention.
Figure 7 shows a schematic top view of a fifth embodiment of a device according to the invention.

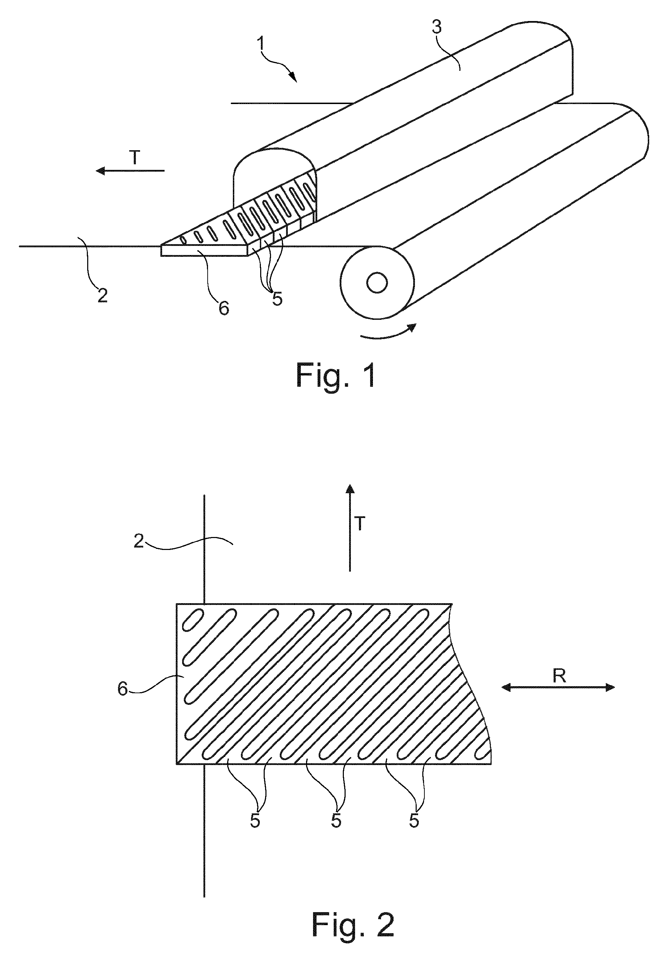

Figure 1 shows a perspective view of a first embodiment of a device 1 according to the invention. The device 1 is arranged over a surface 2, which is to be treated with the device. The surface 2 is transported under the device in the treatment direction T. The device 1 has a housing 3 in which a row 4 of treatment elements 5, 6 is accommodated.

Figure 2 shows a top view of the row of treatment elements 5, 6. The row is formed out of elongate treatment elements 5, which are arranged in an imbricated way in the direction of the row R. At the end of the row elongate elements 5, a triangular treatment element 6 is arranged, such that the combined treatment area of the elongate treatment elements 5 and triangular treatment elements 6 has a rectangular shape.

In this embodiment, the treatment elements 5, 6 are provided with elongate slots, via which for example a spray, plasma or gas can be fed to the surface 2.

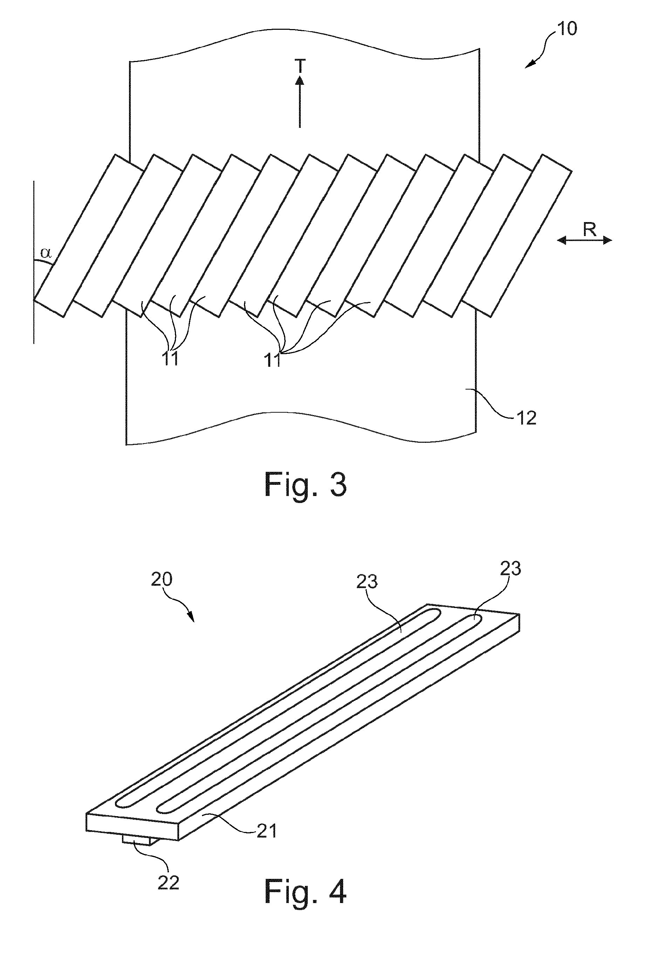

Figure 3 shows a schematic top view of a second embodiment of a device 10 according to the invention. The device 10 has a single row of rectangular, elongate treatment elements 11, which are parallel to each other and are arranged in an imbricated way in the direction of the row R. The angle α of the longitudinal axis of a treatment element 11 and the treatment direction T is preferably equal to or larger than 0° and smaller than 90°. With the rectangular elongate treatment elements 11 it is possible to have the angle α adjustable depending on the desired treatment of the surface 12.

Figure 4 shows a very preferred embodiment of an elongate treatment element 20 for a device according to the invention. This elongate treatment element 20 has a rectangular ceramic plate 21 on which a ground electrode 22 and two high voltage electrodes 23 are arranged. By providing a high frequency voltage on the electrodes 23, a plasma of the gas surrounding the electrodes 23 is created. Such a elongate treatment element is known as a surface dielectric barrier discharge plasma element. The position of the electrodes 22 and 23 can also be interchanged for such a plasma generating treatment element. Furthermore, a cooling block could be arranged on the top of the treatment element, for example integrated with the ground electrode 22.

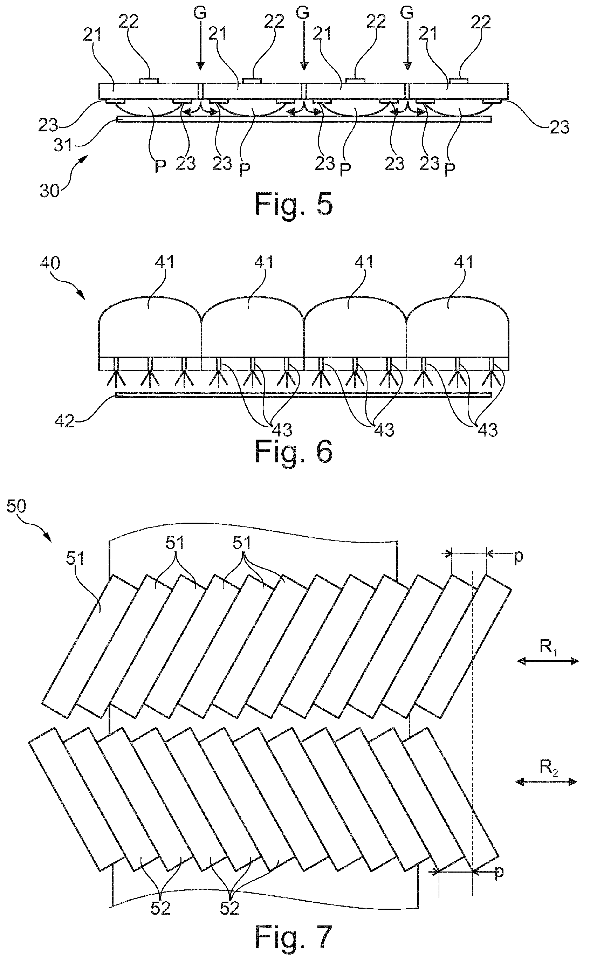

Figure 5 shows a cross sectional view of a third embodiment of a device 30 according to the invention. This device 30 comprises a row of surface dielectric barrier discharge plasma elements 20 as shown in figure 4.

The ceramic plates 21 are arranged at a small distance, such that a gap is created between the ceramic plates 21. Via these gaps a gas G can be supplied to the electrodes 23 in order to create a plasma P of this gas G. This plasma P is then deposited on the surface 31.

As is clear from this cross section, the plasma P is not continuous in this embodiment, but due to the imbricated arrangement of the elongate elements 20 and the transportation of the surface 31 underneath the device 30 ensures, that the surface 31 will be treated homogeneously by the plasma P.

Figure 6 shows a fourth embodiment of a device 40 according to the invention. The device 40 has a number of treatment elements 41 arranged in imbricated way over a surface 42 to be treated. The treatment elements 41 have at the bottom a surface perforated with holes 43, through which for example a gas or spray can be applied to the surface 42.

Figure 7 shows a schematic top view of a fifth embodiment of a device 50 according to the invention. The device 50 has two rows R1, R2 with respectively treatment elements 51 and 52.

Compared to the longitudinal axes of the elements 51, the longitudinal axes of the elements 52 are mirrored relative to the direction of the rows R1, R2.

Furthermore, the row R2 is shifted in the direction of the row R2 over half the length of the pitch p between elements 51 or 52.

## Claims

1. Device for treating a surface by moving the device over the surface in a treatment direction, which device comprises a number of treatment elements arranged in at least one row, **characterized in that** the treatment elements within a row are parallel to each other and wherein the longitudinal axis of each treatment element has at least, in use, a directional component parallel to the treatment direction.

2. Device according to claim 1, wherein the treatment elements are arranged in an imbricated way in the direction of the row.

3. Device according to claim 2, wherein the longitudinal axis of each treatment element is under an angle with the treatment direction and wherein the direction of the longitudinal axis of each treatment element differs from both the treatment direction and the direction of the at least one row.

4. Device according to any of the preceding claims, wherein the angle between the longitudinal axis of each treatment element and the treatment direction is equal to or larger than 0° and smaller than 90°.

5. Device according to any of the preceding claims, wherein the treatment elements are surface dielectric barrier discharge plasma heads having linear electrodes extending in longitudinal direction of the elements.

6. Device according to claim 5, further comprising two triangular treatment elements each arranged at an end of the at least one row oftreatment elements to obtain a rectangular treatment area.

7. Device according to any of the preceding claims, comprising at least two parallel rows of treatment elements, wherein the longitudinal axes of the elements of adjacent rows are mirrored relative to the direction of the rows.

8. Device according to any of the preceding claims, wherein adjacent rows are displaced in longitudinal direction of the rows.

9. Device according to claim 8, wherein the displacement of adjacent rows equals the pitch between adjacent treatment elements divided by the number of rows.

10. Device according to any of the preceding claims, wherein a gap is provided between adjacent treatment elements for supplying a treatment gas between the treatment elements and the surface to be treated or for discharging a treatment gas therefrom.

11. Device according to any of the preceding claims, further comprising control means for separately controlling the power of the treatment elements.

12. Device according to any of the preceding claims, further comprising a housing for accommodating the at least one row of treatment elements, wherein the housing has a gas inlet for providing a treatment gas to the treatment elements and a gas outlet for discharging the treatment gas from the treatment elements.

13. Device according to any of the preceding claims, wherein the treatment elements are elongate.
